# FASCICULE DE BREVET EUROPEEN

(11) **EP 0 720 420 B1**
(45) Date de publication et mention de la délivrance du brevet: **29.04.1998**
(21) Numéro de dépôt: 95410145.7
(22) Date de dépôt: 19.12.1995
(51) Int. Cl.: H05K 7/20, H01L 23/473

(54) **Elément refroidisseur et connecteur pour un composant électronique refroidi par un fluide électriquement isolé du composant**
Körper und Verbindung zur Kühlung eines elektronischen Bausteines durch eine von ihm elektrisch isolierte Flüssigkeit
Heat sink and connector for cooling an electronic component by a fluid isolated from it

(30) Priorité: 30.12.1994 FR 9416008
(43) Date de publication de la demande: 03.07.1996
(73) Titulaire: ATHERM, 38420 Domene (FR)
(72) Inventeur: Teytu, André, F-38100 Grenoble (FR); Godet, Claude, F-38410 St. Martin d'Uriage (FR)
(74) Mandataire: Hecké, Gérard

(56) Documents cités:
- EP-A- 0 234 021
- DE-U- 8 801 086
- FR-A- 2 523 289

## Description

L'invention est relative à un élément refroidisseur comprenant un corps réalisé en un matériau métallique bon conducteur de la chaleur et de l'électricité, et conformé en radiateur à travers lequel circule un fluide de refroidissement, ledit corps ayant une face de support d'un composant électronique de puissance constituant la source de chaleur, cf. par exemple EP-A-0 234 021.

Un composant électronique de puissance, notamment un thyristor ou transistor pour un convertisseur statique, est généralement formé par un disque dont les faces planes servent à l'évacuation des pertes thermiques pouvant atteindre plusieurs centaines de watts. Les mêmes faces du composant assurent également le passage du courant électrique, dont l'intensité peut atteindre plusieurs milliers d'ampères.

Il est donc impératif que le fluide de refroidissement ne soit pas porté au potentiel électrique des faces du composant.

A cet effet, il a déjà été proposé de faire usage d'un fluide caloporteur non conducteur de l'électricité. Il s'agit généralement de fluides du type chlorofluoro carbone, soit des fluides fluoro carbonés dont l'utilisation est aujourd'hui soit prohibée, soit fortement déconseillée.

Certains ont proposé un refroidissement par un circuit d'eau désionisée dont la résistivité élevée assure l'isolement du circuit de refroidissement. L'inconvénient de ce procédé est de nécessiter un dispositif de régénération fonctionnant en permanence pour maintenir la résistivité de l'eau à un niveau suffisant.

Des dispositifs de refroidissement entièrement réalisés en matériau isolant électrique ont été proposés, mais les connexions électriques doivent être effectuées par des plaques de cuivre interposées entre le refroidisseur et le composant électronique. Cette solution, outre sa complexité relative au moment de l'assemblage, présente l'inconvénient d'engendrer des résistances thermiques de contact entre la source de chaleur et le refroidisseur, ce qui diminue l'efficacité de ce dernier.

Un premier objet de l'invention consiste à améliorer l'échange thermique entre le fluide et le corps de l'élément refroidisseur sur lequel est monté le composant.

Un deuxième objet de l'invention consiste à renforcer l'isolement du circuit de fluide par rapport au composant.

L'élément refroidisseur selon l'invention est caractérisé en ce que le corps comporte une pluralité d'orifices traversés axialement par des tubes de circulation du fluide, chaque tube ayant un diamètre légèrement inférieur à celui de l'orifice, et étant réalisé en un matériau isolant et bon conducteur de la chaleur, et que l'interstice annulaire ménagé entre chaque tube et l'orifice correspondant est rempli au moyen d'un alliage métallique, autorisant un échange thermique optimum entre la source de chaleur et le fluide de refroidissement, l'introduction de l'alliage s'effectuant à travers un orifice de remplissage ménagé dans le corps.

Lors de son refroidissement, l'alliage métallique a la propriété d'augmenter de volume, ce qui procure un effet d'expansion du métal, de manière à obtenir une couche intermédiaire uniforme, évitant toute résistance thermique de contact avec la paroi du corps sur toute la longueur des orifices.

L'alliage constitutif de cette couche intermédiaire reste suffisamment mou après le changement d'état, pour autoriser des dilatations différentielles lors des variations de température du corps.

Selon une caractéristique de l'invention, les tubes de circulation du fluide sont raccordés à une paire de collecteurs accolés aux faces de jonction opposées du corps, chaque collecteur étant réalisé en un matériau isolant.

Chaque collecteur est équipé le long de la première face d'appui plane d'une pluralité d'alvéoles pour la réception des bouts opposés des tubes, et d'une tubulure commune faisant communiquer les tubes respectivement avec un embout d'admission, et un embout d'échappement associés à un circuit de distribution du fluide.

Selon une autre caractéristique préférentielle de l'invention, le matériau du tube est en céramique, notamment en alumine ou en nitrure d'aluminium. L'alliage métallique de remplissage des interstices est à base de plomb d'étain et de bismuth présentant un point de fusion relativement bas..

L'échange thermique peut encore être amélioré en prévoyant à l'intérieur des tubes des moyens de guidage destinés à faire circuler le fluide selon un écoulement turbulent à trajectoire hélicoïdale lors de son passage dans le corps. Les moyens de guidage du fluide comportent un organe turbulateur coopérant avec des moyens de fixation pour l'assemblage des deux collecteurs sur le corps. Les moyens de fixation sont formés par des vis logées dans une série de lumières située dans la deuxième face externe de chaque collecteur à l'opposé de la première face d'appui, lesdites vis se trouvant en alignement axial avec les alvéoles et les tubes correspondants.

Une telle structure d'élément refroidisseur autorise l'usage d'eau ordinaire dans le circuit de refroidissement. La tension d'isolement de l'eau par rapport au composant atteint 20 kV, étant donné que les cavités annulaires agencées au niveau des collecteurs entre les bouts des tubes et les alvéoles sont remplies par une substance diélectrique, notamment à base de résine, laquelle est injectée à travers des trous débouchant dans les alvéoles.

D'autres avantages et caractéristiques ressortiront plus clairement de la description qui va suivre d'un mode de réalisation de l'invention, donné à titre d'exemple non limitatif, et représenté aux dessins annexés, dans lesquels:
- la figure 1 est une vue en élévation, partiellement représentée en coupe de l'élément refroidisseur selon l'invention;
- la figure 2 montre une vue en coupe à échelle agrandie du corps de l'élément de la figure 1;
- la figure 3 représente une vue en coupe selon la ligne brisée 3-3 de la figure 2;
- la figure 4 montre une vue en coupe du collecteur d'admission de l'élément refroidisseur de la figure 1, l'embout d'admission n'étant pas représenté;
- la figure 5 est une vue de profil de la figure 4;
- la figure 6 est une vue de l'organe turbulateur destiné à être engagé dans chaque tube du corps de la figure 1;
- la figure 7 est une vue de détail à échelle agrandie de la figure 6;

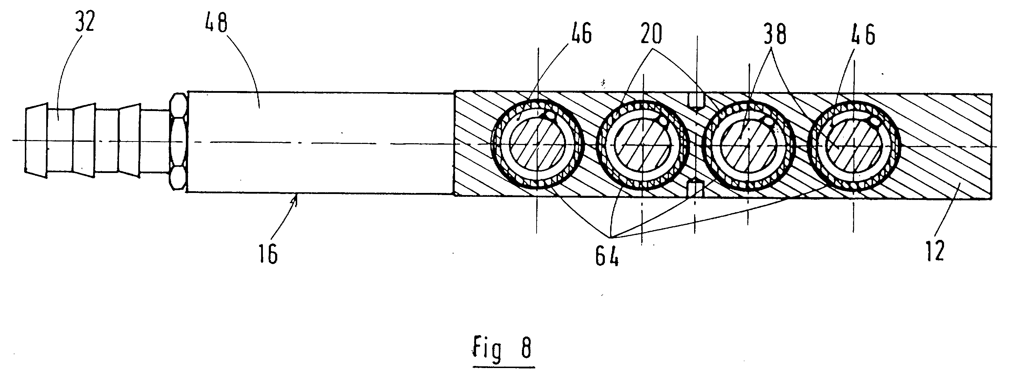

- la figure 8 est une vue en coupe selon la ligne 8-8 de la figure 1.

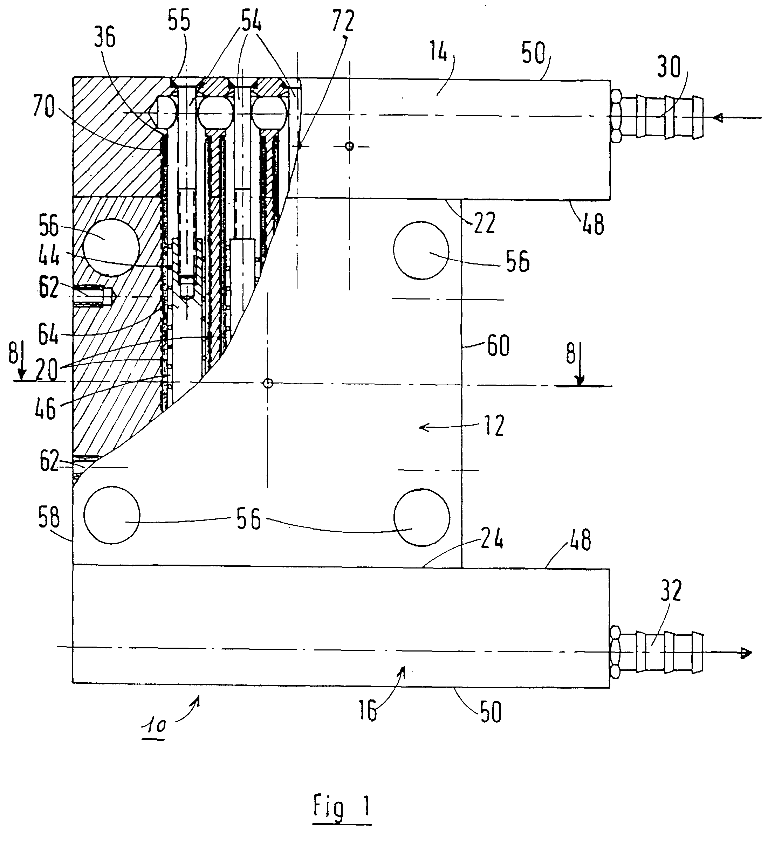

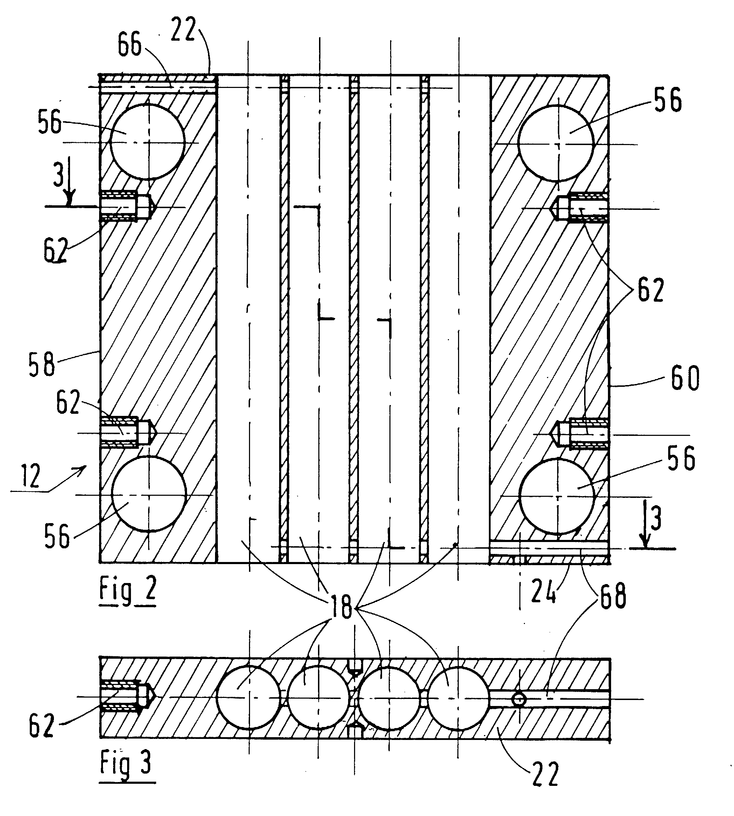

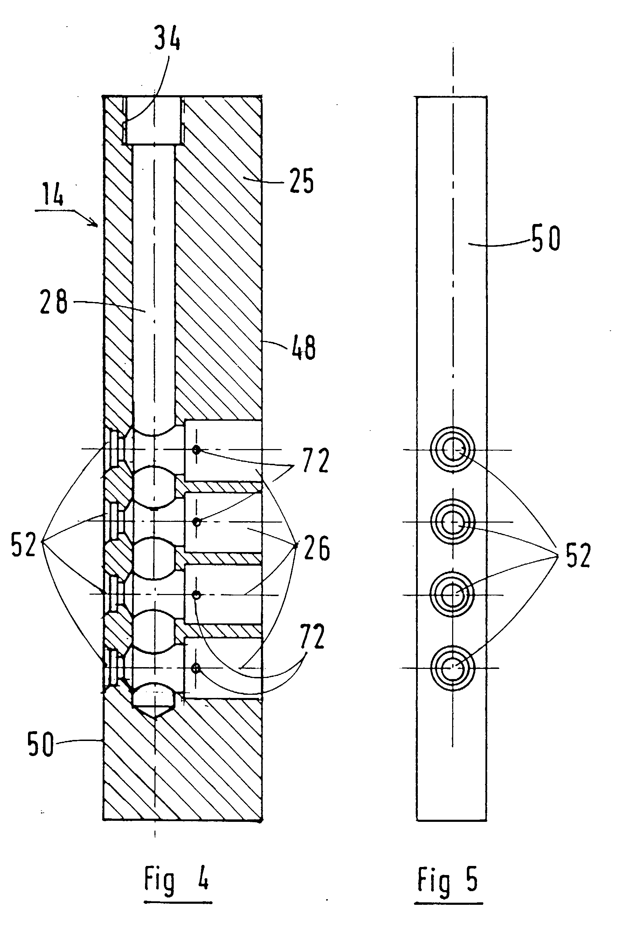

En référence aux figures 1 à 7, un élément refroidisseur et connecteur 10 pour au moins un composant électronique, comporte un corps 12 quadrangulaire de support du composant , et deux collecteurs 14,16 allongés encadrant le corps 12 pour autoriser la circulation d'un fluide de refroidissement. Le corps 12 constitue un radiateur réalisé en un matériau bon conducteur de la chaleur et de l'électricité, notamment de l'aluminium ou du cuivre, et est percé d'une série d'orifices 18 parallèles et de sections circulaires.

Chaque orifice 18 est traversé axialement par un tube 20 à l'intérieur duquel circule le liquide de refroidissement. La longueur des tubes 20 est supérieure à celle des orifices 18, et les extrémités opposées des tubes 20 font saillie des faces de jonction 22,24 du corps 12. Chaque tube 20 présente un diamètre légèrement inférieur à celui de l'orifice 18, et est réalisé en un matériau isolant et bon conducteur de la chaleur, par exemple en alumine ou en nitrure d'aluminium. Tout autre matériau en céramique peut bien entendu être utilisé.

Chaque collecteur 14,16 du fluide de refroidissement comprend un bloc 25 en matériau isolant, notamment moulé ou usiné dans la masse. Le bloc 25 est équipé d'une pluralité d'alvéoles 26 de réception des extrémités des tubes 20, et d'une tubulure 28 commune s'étendant perpendiculairement aux alvéoles 26 en les faisant communiquer, respectivement avec un embout d'admission 30 et un embout d'échappement 32. Chaque embout 30,32 est formé par une douille cannelée mâle, vissée dans un orifice 34 taraudé à l'entrée de la tubulure 28 du collecteur 14,16 correspondant, et susceptible d'être raccordée à un circuit de distribution du fluide.Toute autre forme d'embout peut bien entendu être utilisée pour le raccordement, notamment un embout venant directement de moulage avec le bloc 25 du collecteur 14, 16.

Les alvéoles 26 internes du bloc 25 se trouvent placés coaxialement en regard des orifices 18 du corps 12, et présentent sensiblement les mêmes diamètres. Un premier joint 36 torique est placé au fond de chaque alvéole 26 pour assurer l'étanchéité avec l'extrémité du tube 20 lors de l'assemblage des collecteurs 14,16 avec le corps 12.

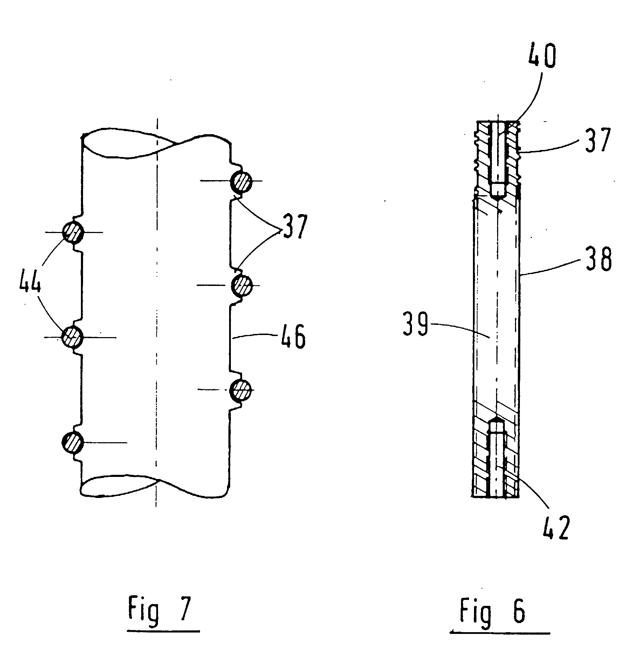

A l'intérieur de chaque tube 20 isolant se trouvent des moyens de guidage destinés à faire circuler le fluide selon un écoulement turbulent de trajectoire hélicoïdale, lors de son passage dans le corps 12. Un exemple de réalisation de ces moyens de guidage est représenté sur les figures 6 et 7, illustrant un organe turbulateur 38, formé par une barrette 39 d'aluminium comprenant une saignée 37 en hélice le long de la surface latérale cylindrique. Les extrémités opposées de chaque barrette 39 sont dotées de trous 40, 42 borgnes taraudés, et un fil d'étanchéité 44, notamment à base de caoutchouc, est logé dans la saignée 37, de manière à venir en engagement avec la surface interne de chaque tube 20. La circulation du fluide de refroidissement dans le corps 12 s'opère dans une pluralité de canaux 46 hélicoïdaux situés entre la barrette 39 et la surface interne de chaque tube 20. Il en résulte un écoulement turbulent à grande vitesse qui permet d'obtenir un échange thermique optimum.

Le choix du diamètre de la barrette 39, et/ou du pas de la saignée 37 en hélice, permettent d'adapter la perte de charge et le débit à l'intérieur du corps 12 en fonction des paramètres de l'installation.

Les alvéoles 26 de chaque collecteur 14,16 débouchent du côté de la première face d'appui 48 plane destinée à être accolée avec la face de jonction 22,24 conjuguée du corps 12. A l'opposé de la première face d'appui 48, s'étend parallèlement une deuxième face 50 externe, comportant une série de lumières 52 pour le passage de moyens de fixation formés par des vis 54.

Les lumières 52 de chaque collecteur 14,16 se trouvent dans l'alignement axial avec les alvéoles 26 et les tubes 20 correspondants, de manière à autoriser l'introduction des vis 54 dans les trous 40,42 agencés sur les faces frontales des organes turbulateurs 38. Le vissage de l'ensemble des vis 54 assure un serrage efficace des deux collecteurs 14,16 sur le corps 12 central. Un deuxième joint 55 torique est introduit dans chaque lumière 52 pour l'étanchéité sous la tête de vis 54.

Aux quatre coins du corps 12 peuvent être disposés des trous 56 circulaires s'étendant orthogonalement aux orifices 18, et autorisant le passage de moyens d'assemblage lors de l'empilage de plusieurs éléments refroidisseurs 10. Les deux autres faces 58,60 opposées du corps 12 qui ne sont pas en contact avec les collecteurs 14,16, sont pourvues de moyens de connexion 62 pour le raccordement électrique du composant.

Pour que l'échange thermique entre le fluide de refroidissement et le corps 12 soit optimum, les interstices 64 annulaires ménagés entre la surface externe des tubes 20 et la surface latérale des orifices 18, sont remplis au moyen d'un alliage métallique à bas point de fusion, notamment à base de plomb, d'étain et de bismuth. Le corps 12 comporte à effet deux orifices de remplissage 66,68 accessibles depuis chaque face latérale 58,60, et mis en communication à travers les différents interstices 64.

Le procédé de mise en oeuvre de l'élément refroidisseur 10 selon l'invention s'effectue de la manière suivante:

Après la mise en place des tubes 20 dans le corps 12, l'ensemble est placé dans un moule et soumis à une première opération de chauffage à une température prédéterminée. A la suite d'une deuxième opération de mise sous vide du moule, l'alliage fondu est injecté dans le moule par l'orifice de remplissage aval 68 jusqu'au remplissage total de tous les interstices 64 annulaires.

A la fin de cette troisième opération de coulée sous vide, le refroidissement progressif du métal de l'alliage métallique provoque un effet d'expansion du métal de manière à éviter toute résistance thermique de contact avec la paroi du corps 12 sur toute la longueur des orifices 18. L'alliage refroidi reste suffisamment mou pour autoriser des dilatations différentielles lors des variations de température du corps 12.

Le corps 12 équipé de ses tubes 20 est ensuite retiré du moule, et la quatrième opération de montage peut alors commencer. Les organes turbulateurs 38 sont engagés dans les tubes 20, suivi de l'accolement des deux collecteurs 14,16 isolants contre les faces de jonction 22,24 du corps 12, avec introduction des bouts des tubes 20 dans les alvéoles 26 correspondants. L'assemblage définitif s'opère ensuite par vissage des vis 54 dans les trous 40,42 taraudés des barrettes 39.

Au cours d'une dernière opération, les cavités 70 annulaires agencées au niveau des collecteurs 14,16 entre les extrémités des tubes 20 et les alvéoles 26 sont remplies par une substance diélectrique à base de résine, injectée à travers des trous 72 débouchant dans les alvéoles 26. Le remplissage total de ces cavités 70 par la résine renforce la tenue diélectrique entre le circuit de refroidissement et le corps 12 métallique.

Il est possible de faire usage d'eau ordinaire (avec ou sans antigel) dans le circuit de refroidissement, et la tension d'isolement par rapport au composant peut atteindre 20 kV. Tout autre fluide de refroidissement peut bien entendu être utilisé, dans un circuit de distribution sous pression ou avec circulateur.

Selon une variante, les organes turbulateurs 38 peuvent être obtenus par moulage d'un matériau plastique, avec des lèvres d'étanchéité suffisamment souples remplaçant le fil 44.

## Revendications

1. Élément refroidisseur et connecteur comprenant un corps réalisé en un matériau métallique bon conducteur de la chaleur et de l'électricité, et conformé en radiateur à travers lequel circule un fluide de refroidissement, ledit corps ayant une face de support d'un composant électronique de puissance constituant la source de chaleur, caractérisé en ce que:
- le corps (12) comporte une pluralité d'orifices (18) traversés axialement par des tubes (20) de circulation du fluide, chaque tube (20) ayant un diamètre légèrement inférieur à celui de l'orifice (18), et étant réalisé en un matériau isolant électrique et bon conducteur de la chaleur,
- et l'interstice (64) annulaire ménagé entre chaque tube (20) et l'orifice (18) correspondant, est rempli au moyen d'un alliage métallique, autorisant un échange thermique optimum entre la source de chaleur et le fluide de refroidissement, l'introduction de l'alliage s'effectuant à travers un orifice de remplissage (68) ménagé dans le corps (12).

2. Élément refroidisseur selon la revendication 1, caractérisé en ce que les tubes (20) de circulation du fluide sont raccordés à une paire de collecteurs (14,16) accolés aux faces de jonction (22,24) opposées du corps (12), chaque collecteur (14,16) étant réalisé en un matériau isolant.

3. Élément refroidisseur selon la revendication 2, caractérisé en ce que chaque collecteur (14,16) est équipé le long de la première face d'appui (48) plane d'une pluralité d'alvéoles (26) pour la réception des bouts opposés des tubes (20), et d'une tubulure (28) commune faisant communiquer les tubes (20) respectivement avec un embout d'admission (30), et un embout d'échappement (32) associés à un circuit de distribution du fluide.

4. Élément refroidisseur selon la revendication 1, caractérisé en ce que chaque tube (20) possède une longueur supérieure à celle de l'orifice (18) associé, et que le matériau du tube (20) est en céramique, notamment en alumine ou en nitrure d'aluminium.

5. Élément refroidisseur selon la revendication 1, caractérisé en ce que l'alliage métallique pour le remplissage des interstices (64) est à base de plomb, d'étain et de bismuth ayant un point de fusion relativement bas, et que le remplissage s'opère au moyen d'une opération de coulée sous vide.

6. Élément refroidisseur selon l'une des revendications 1 à 3, caractérisé en ce que chaque tube (20) isolant renferme des moyens de guidage destinés à faire circuler le fluide dans le corps (12) selon un écoulement turbulent, notamment à trajectoire hélicoïdale.

7. Élément refroidisseur selon la revendication 6, caractérisé en ce que :
- les moyens de guidage du fluide comportent un organe turbulateur (38) coopérant avec des moyens de fixation pour l'assemblage des deux collecteurs (14,16) sur le corps (12),
- et les moyens de fixation sont formés par des vis (54) logées dans une série de lumières (52) située dans la deuxième face externe (50) de chaque collecteur (14,16) à l'opposé de la première face d'appui (48), lesdites vis se trouvant en alignement axial avec les alvéoles (26) et les tubes (20) correspondants.

8. Élément refroidisseur selon la revendication 7, caractérisé en ce que l'organe turbulateur (38) comprend une barrette (39) métallique ayant une saignée (37) en hélice le long de la surface latérale cylindrique, et un fil d'étanchéité (44) logé dans la saignée (37), et que ledit fil d'étanchéité (44) vient en engagement avec la surface interne du tube (20) de manière à constituer un canal (46) hélicoïdal dans lequel circule le fluide de refroidissement à grande vitesse.

9. Élément refroidisseur selon la revendication 8, caractérisé en ce que :
- la barrette (39) est dotée aux extrémités opposées de deux trous borgnes (40,42) taraudés, destinés au vissage d'une paire de vis (54) traversant les bouts opposés du tube (20) associé,
- un premier joint (36) est placé au fond des alvéoles (26) de chaque collecteur (14,16) pour assurer l'étanchéité avec les bouts opposés des tubes 20,
- et un deuxième joint (55) est introduit dans chaque lumière (52) pour assurer l'étanchéité sous la tête des vis (54).

10. Élément refroidisseur selon l'une des revendications 3 à 9, caractérisé en ce que le fluide de refroidissement est constitué par de l'eau, et que les cavités (70) annulaires agencées au niveau des collecteurs (14,16) entre les bouts des tubes (20) et les alvéoles (26) sont remplies par une substance diélectrique, notamment à base de résine, laquelle est injectée à travers des trous (72) débouchant dans les alvéoles (26).

## Patentansprüche

1. Kühl- und Anschluss-Element, mit einem Körper, der aus einem metallischen, gut die Wärme und Elektrizität leitendem Material hergestellt ist, und als Radiator ausgebildet ist, durch den eine Kühlflüssigkeit fliesst, wobei dieser Körper eine Tragfläche eines elektronischen Leistungsbestandteils aufweist, der die Wärmequelle bildet, dadurch gekennzeichnet, dass :
- der Körper (12) eine Mehrzahl von Öffnungen (18) aufweist, die von den Flüssigkeitszirkulations-Rohren (20) axial durchquert werden, wobei jedes Rohr (20) einen etwas genngeren Durchmesser als die Öffnung (18) aufweist, und aus einem elektrischen Isoliermaterial hergetellt ist, das gut die Wärme leitet,
- der zwischen jedem Rohr (20) und der entsprechenden Öffnung (18) vorgesehene ringförmige Zwischenraum (64) mit einer Metall-Legierung gefüllt ist, was einen optimalen Wärmeaustausch zwischen der Wärmequelle und der Kühlflüssigkeit erlaubt, wobei das Einfüllen der Legierung durch eine im Körper (12) vorgesehene Einfüllöffnung (68) ausgeführt wird.

2. Kühlelement gemäss Anspruch 1, dadurch gekennzeichnet, dass die Flüssigkeitszirkulations-Rohre (20) an ein Paar Sammler (14, 16) angeschlossen sind, die den gegenüberliegenden Verbundflächen (22, 24) des Körpers (12) angefügt sind, wobei jeder Sammler (14, 16) aus Isolier-Material hergestellt ist.

3. Kühlelement gemäss Anspruch 2, dadurch gekennzeichnet, dass jeder Sammler (14, 16) entlang der ersten ebenen Stützfläche (48) mit einer Mehrzahl von Zellen (26) ausgerüstet ist für die Aufnahme der entgegengesetzten Enden der Rohre (20) und mit einem gemeinsamen Rohransatz (28), der die Rohre (20) mit einem Einlass-Übergangsstück (30) bzw. einem Auslass-Übergangsstück (32) in Verbindung bringt, die mit einem Flüssigkeits-Verteilerkreis vereint sind.

4. Kühlelement gemäss Anspruch 1, dadurch gekennzeichnet, dass jedes Rohr (20) eine Länge aufweist, die grösser als die Länge der zugeordneten Öffnung (18) ist, und dass das Material des Rohres (20) aus Keramik besteht, insbesondere aus Aluminiumoxyd oder aus Aluminium-Nitrid.

5. Kühlelement gemäss Anspruch 1, dadurch gekennzeichnet, dass die Metall-Legierung zur Füllung der Zwischenräume (64) aus Blei, Zinn und Wismut mit einem relativ niedrigen Schmelzpunkt besteht, und dass das Einfüllen mittels einem Gussvorgang im Vakuum erfolgt.

6. Kühlelement gemäss einem der Ansprüche 1 bis 3, dadurch gekennzeichnet, dass jedes lsolierrohr (20) Führungsmittel umschliesst, die dazu bestimmt sind, die Flüssigkeit in dem Körper (12) umlaufen zu lassen gemäss einem Turbulenz-Abfluss, insbesondere mit einem spiralförmigen Bewegungsverlauf.

7. Kühlelement gemäss Anspruch 6, dadurch gekennzeichnet, dass
- die Führungsmittel der Flüssigkeit ein Turbulenzelement (38) aufweisen, das mit den Befestigungsmitteln zum Zusammenfügen der beiden Sammler (14, 16) auf dem Körper (12) zusammenarbeitet,
- und die Befestigungsmittel von Schrauben (54) gebildet sind, die in einer Reihe von Öffnungen (52) angeordnet sind, welche in der zweiten Aussenfläche (50) jedes Sammlers (14, 16) gelegen sind, gegenüber der ersten Stützfläche (48), wobei sich die genannten Schrauben in axialer Ausrichtung mit den Zellen (26) und den entsprechenden Rohren (20) befinden.

8. Kühlelement gemäss Anspruch 7, dadurch gekennzeichnet dass das Turbulenzelement (38) eine kleine Metallschiene (39) aufweist mit einer schraubenförmigen Einkerbung (37) entlang der zylindrischen seitlichen Oberfläche, und mit einem in der Einkerbung (37) angeordneten Dichtungsdraht (44), und dass der genannte Dichtungsdraht (44) mit der inneren Oberfläche des Rohres (20) zusammenwirkt, um einen spiralförmigen Kanal (46) zu bilden, in dem die Kühlflüssigkeit mit grosser Geschwindigkeit zirkuliert.

9. Kühlelement gemäss Anspruch 8, dadurch gekennzeichnet, dass
- die Schiene (39) an den entgegengesetzten Enden mit zwei blinden Gewindelöchern (40, 42) versehen ist, die zum Einschrauben eines Schraubenpaars (54) bestimmt sind, welche die entgegengesetzten Enden des zugeordneten Rohres (20) durchqueren,
- eine erste Dichtung (36) auf dem Boden der Zellen (26) jedes Sammlers (14, 16) angebracht ist, um die Dichtheit mit den entgegengesetzten Enden der Rohre (20) zu gewährleisten,
- und eine zweite Dichtung (55) in jede Öffnung (52) eingefügt ist, um die Dichtheit unter den Schraubenköpfen (54) zu gewährleisten.

10. Kühlelement gemäss einem der Ansprüche 3 bis 9, dadurch gekennzeichnet, dass die Kühlflüssigkeit aus Wasser besteht, und dass die ringförmigen Hohlräume (70), die auf der Höhe der Sammler (14, 16) zwischen den Enden der Rohre (20) und den Zellen (26) angeordnet sind, mit einer dielektrischen Substanz gefüllt werden, die insbesondere auf Harzbasis beruht, und die durch die Löcher (72) eingefüllt wird, die in die Zellen (26) einmünden.

## Claims

1. A cooling element and connector comprising a body made of a good heat and electricity conducting metallic material, and forming a heat sink through which a cooling fluid flows, said body having a support face of an electronic power component constituting the heat source, characterized in that :
- the body (12) comprises a plurality of orifices (18) through which fluid circulation tubes (20) pass axially, each tube (20) having a diameter slightly smaller than that of the orifice (18), and being made of an electrical insulating and good heat conducting material,
- and the annular gap (64) arranged between each tube (20) and the corresponding orifice (18) is filled by means of a metallic alloy, enabling an optimum heat exchange between the heat source and the cooling fluid, insertion of the alloy being performed via a filling orifice (68) arranged in the body (12).

2. The cooling element according to claim 1, characterized in that the fluid circulation tubes (20) are connected by a pair of manifolds (14, 16) adjoined to the opposite joining faces (22, 24) of the body (12), each manifold (14, 16) being made of an insulating material.

3. The cooling element according to claim 2, characterized in that each manifold (14, 16) is equipped along the first flat bearing face (48) with a plurality of recesses (26) to receive the opposite ends of the tubes (20), and with a common pipe (28) making the tubes (20) communicate respectively with an inlet nozzle (30) and an outlet nozzle (32) associated to a fluid distribution circuit.

4. The cooling element according to claim 1, characterized in that each tube (20) has a length greater than that of the associated orifice (18), and that the material of the tube (20) is made of ceramic, notably alumina or aluminium nitride.

5. The cooling element according to claim 1, characterized in that the metallic alloy for filling the gaps (64) is lead, tin and bismuth based having a relatively low melting point, and that filling is performed by means of a vacuum casting operation.

6. The cooling element according to one of the claims 1 to 3, characterized in that each isolating tube (20) contains guide means designed to make the fluid circulate in the body (12) according to a turbulent flow, notably with a helicoidal trajectory.

7. The cooling element according to claim 6, characterized in that :
- the fluid guide means comprise a turbulating device (38) cooperating with fixing means for assembly of the two manifolds (14, 16) on the body (12),
- and the fixing means are formed by screws (54) housed in a series of apertures (52) located in the second external face (50) of each manifold (14, 16) opposite the first bearing face (48), said screws being in axial alignment with the recesses (26) and corresponding tubes (20).

8. The cooling element according to claim 7, characterized in that the turbulating device (38) comprises a metallic strip (39) having a spiral groove (37) along the cylindrical lateral surface, and a sealing wire (44) housed in the groove (37), and that said sealing wire (44) comes into engagement with the internal surface of the tube (20) so as to form a spiral canal (46) in which the cooling fluid flows at high speed.

9. The cooling element according to claim 8, characterized in that :
- the strip (39) is provided at the opposite ends with two tapped blind holes (40, 42), designed for screwing a pair of screws (54) passing through the opposite ends of the associated tube (20),
- a first seal (36) is placed at the bottom of the recesses (26) of each manifold (14, 16) to provide the leak tightness with the opposite ends of the tubes (20),
- and a second seal (55) is inserted into each aperture (52) to provide the leak tightness under the head of the screws (54).

10. The cooling element according to one of the claims 3 to 9, characterized in that the cooling fluid is formed by water, and that the annular cavities (70) arranged at the level of the manifolds (14, 16) between the ends of the tubes (20) and the recesses (26) are filled with a dielectric substance, notably resin-based, which is injected via holes (72) which outlet into the recesses (26).
